(19) Europäisches Patentamt
European Patent Office
Office européen des brevets

(11) **EP 0 916 099 B1**

(12) **EUROPÄISCHE PATENTSCHRIFT**

(45) Veröffentlichungstag und Bekanntmachung des Hinweises auf die Patenterteilung:
**22.10.2003 Patentblatt 2003/43**

(21) Anmeldenummer: **97936681.2**

(22) Anmeldetag: **05.08.1997**

(51) Int Cl.⁷: **G01T 1/28**

(86) Internationale Anmeldenummer:
**PCT/EP97/04243**

(87) Internationale Veröffentlichungsnummer:
**WO 98/005979 (12.02.1998 Gazette 1998/06)**

(54) **RÖNTGEN- ODER GAMMA-PHOTONENDETEKTORANORDNUNG MIT GLASFASERKÖRPER MIT GEKRÜMMTER EINGANGSFLÄCHE**

X-RAY OR GAMMA PHOTON DETECTOR ARRANGEMENT WITH A FIBRE OPTIC TAPER WITH A CURVED INPUT SURFACE

DISPOSITIF DE DETECTION POUR RAYONS X OU PHOTONS GAMMA AVEC CORPS EN FIBRES DE VERRE PRESENTANT UNE SURFACE D'ENTREE COURBEE

(84) Benannte Vertragsstaaten:
**CH DE FR GB IT LI NL SE**

(30) Priorität: **05.08.1996 DE 29613558 U**

(43) Veröffentlichungstag der Anmeldung:
**19.05.1999 Patentblatt 1999/20**

(73) Patentinhaber: **Hendrix, Jules**
**22605 Hamburg (DE)**

(72) Erfinder: **Hendrix, Jules**
**22605 Hamburg (DE)**

(74) Vertreter: **Gerbaulet, Hannes, Dipl.-Ing.**
**Patentanwälte**
**Richter, Werdermann Gerbaulet & Hofmann**
**Neuer Wall 10**
**20354 Hamburg (DE)**

(56) Entgegenhaltungen:
WO-A-94/24600    WO-A-96/41149
FR-A- 2 597 254    US-A- 4 914 284

- **PATENT ABSTRACTS OF JAPAN vol. 005, no. 056 (P-057), 17.April 1981 & JP 56 010270 A (SUMITOMO ELECTRIC IND LTD), 2.Februar 1981,**
- **GAO T ET AL: "AN ECONOMICAL X-RAY AREA DETECTOR BASED ON AN INTENSIFIED CCD UNIT" REVIEW OF SCIENTIFIC INSTRUMENTS, Bd. 64, Nr. 2, Februar 1993, Seiten 390-396, XP000349065**

**Beschreibung**

Technisches Gebiet

Die Erfindung geht aus von einer Detektoranordnung für Photonen, insbesondere Röntgen- oder Gamma-Quanten, mit einem Glasfaserkörper, der eine Schirmfläche zur Aufnahme von Photonen, eine Detektorfläche mit daran angeordnetem Photonen-Detektor sowie einen dazwischen liegenden Abschnitt aufweist, welcher von der Schirmfläche aufgenommene Photonen zur Detektorfläche leitet.

Stand der Technik

Aus der veröffentlichung PATENT ABSTRACTS OF JAPAN, VOL. 005, No. 065 (P-057) & JP 56 010 270 A ist eine Detektoranordnung zur Feststellung von Chemenkov-Strahlung bekannt, bei der DeDetektorenden von optischen Fasen auf einen gekrümmten Fläche angeordnet said.

Detektoranordnungen mit Photodetektor finden beispielsweise bei der Aufnahme von Röntgenbeugungsbildern in der Einkristallstrukturbestimmung Anwendung. In jüngster Zeit wird als Detektor ein CCD-System (Charged-Coupled-Device) verwendet. Diese CCD-Systeme haben jedoch das Problem, daß ihre Aufnahmefläche sehr klein ist und sie darüber hinaus Röntgenstrahlen im interessierenden Energiebereich nicht direkt detektieren können.

Daher finden Glasfaserkörper, sogenannte "Fibre Optic Tapers" Anwendung, die einerseits durch einen sich verjüngenden Körper die Schirmfläche auf die Größe der Fläche des CCD-Detektors verkleinert abbilden und andererseits durch eine Phosphorschicht auf der Schirmfläche Gamma-Quanten (Röntgenstrahlung) in Photonen anderer Wellenlänge umwandeln, so daß der CCD-Detektor diese detektieren kann. Mit diesen Glasfaserkörpern ist es möglich, Streustrahlung beispielsweise von einem zu analysierenden Objekt zu sammeln und auf die Fläche des CCD-Detektors abzubilden.

Die Verwendung dieser bekannten Glasfaserkörper hat den Nachteil, daß eine beispielsweise von einem zu analysierenden Einkristall sphärische Streustrahlung auf die ebene, plane Fläche der Schirmfläche abgebildet wird. Dies führt aufgrund der Projektion zu Verzerrungen der Abbildung. Abgebildete Punkte sind beispielsweise langgestreckte Ovale und die Winkelauflösung nimmt mit zunehmendem Raumwinkel immer mehr ab.

Ferner ist fertigungstechnisch die maximale Ausdehnung derartiger Glasfaserkörper begrenzt. Dies schränkt den möglichen, detektierbaren Raumwinkel erheblich ein. Jedoch wird für fast alle Röntgenanwendungen ein größtmöglich detektierbarer Raumwinkel bzw. eine maximale Schirmfläche gewünscht.

Darstellung der Erfindung, Aufgabe, Lösung, Vorteile

Es ist daher Aufgabe der Erfindung, eine Detektoranordnung der oben genannten Art zur Verfügung zu stellen, die die Detektion eines größtmöglichen Raumwinkels bei minimaler Verzerrung der Abbildung erlaubt. Eine weitere Aufgabe besteht darin, eine größtmögliche Ausdehnung der Schirmfläche für einen bestimmten Durchmesser des Glasfaserkörpers zu erreichen.

Diese Aufgabe wird bei einer Detektoranordnung der oben genannten Art durch die im Anspruch 1 gekennzeichneten Merkmale gelöst.

Hierdurch wird erfindungsgemäß erreicht, daß für einen gegebenen Durchmesser des Glasfaserkörpers die größtmögliche Ausdehnung der Schirmfläche erreicht wird. Vorteilhafterweise ist erreichbar, daß eine signifikant größere Schirmfläche und eine stärkere Verkleinerung dieser Fläche auf dem Detektor erreicht wird, ohne den Nachteil eines übermäßigen Signalverlustes in Kauf nehmen zu müssen.

Dazu ist es erfindungsgemäß vorgesehen, daß die Schirmfläche als gekrümmte Fläche ausgebildet ist, wobei eine an die Anwendung angepaßte Krümmung vorgesehen wird. Diese ist in vorteilhafter Weise kugelschalenförmig, zylinderschalenförmig oder parabelförmig ausgebildet. Dabei wird bevorzugterweise für die Kristallstrukturanalyse eine Kugelschale und für die Pulverdiffratometrie für RCBF und CT-Tomographie eine Zylinderform vorgesehen. Die Krümmung ermöglicht einen Raumwinkel von 180 Grad oder mehr und einen senkrechten Einfall der Streustrahlung auf den Aufnahmeschirm, so daß keine Verzerrungen in der Abbildung auf die Detektorfläche auftreten. Ferner ist es möglich, den Abstand zwischen Kristall und Phosphor so zu bestimmen, daß die Trennung von Reflexionen bzw. die Auflösung der Reflexionswinkel über die gesamte Detektorfläche maximal und nahezu konstant ist.

Bei der besonders bevorzugten Ausführungsform, bei der die gekrümmte Fläche die Form einer Kugelschale hat, hat es sich gezeigt, daß die Form einer Kugelschale die Detektion eines größtmöglichen Raumwinkels erlaubt. Ziel ist es bei der Gestaltung der gekrümmten Fläche, daß insbesondere - im Fall von Röntgenbeugungsaufnahmen - eine minimale Verzerrung der Abbildung erreicht wird und zwar in jede Richtung um den Primärstrahl herum. Es hat sich gezeigt, daß durch die geeignete Auswahl des Abstandes zwischen dem Kristall und der Schirmfläche eine maximale Trennung der Beugungsreflexe erreicht wird.

Einen einfachen Aufbau erzielt man dadurch, daß der Detektor ein CCD-Detektor (Charge-Coupled-Device) ist.

Zur Anpassung der Anordnung an die kleine Fläche des Detektors im Gegensatz zur Schirmfläche verjüngt sich der Abschnitt zwischen Detektorfläche und Schirmfläche in Richtung Detektorfläche derart, daß die Schirmfläche größer als die Detektorfläche ist. Durch die Anwendung von verjüngten Fasern wird die Schirmfläche getreu aber verkleinert auf die Detektorfläche abgebildet.

Eine universelle Einsatzmöglichkeit für unterschiedlichste Photonenenergie erzielt man dadurch, daß auf der Schirmfläche eine Schicht zur Umsetzung von Röntgenstrahlen in Photonen anderer Wellenlänge angeordnet ist.

Die Erfassung nahezu des gesamten Raumwinkels in einer Messung wird dadurch erreicht, daß zwei gekrümmte Flächen derart einander zugewandt angeordnet sind, daß die jeweiligen Zentren der Flächen am selben Raumpunkt liegen.

Die wesentlichen Vorteile ergeben sich bei der verfahrensmäßigen Anwendung der Erfindung in der Kristallographie.

Die gekrümmte Schirmfläche, vorzugsweise als Kugelschale, bringt enorme Vorteile:

1. Größtmögliche Ausdehnung der Schirmfläche, die es erlaubt, mehr Reflexe voneinander getrennt abzubilden.

2. Die Detektion eines größtmöglichen Raumwinkels.

3. Es wird eine größere Schirmfläche und stärkere Verkleinerung dieser Fläche auf den Detektor ohne den Nachteil eines größeren Signalverlustes erreicht.

4. Es wird durch eine geeignete Wahl des Abstandes zwischen dem Kristall und Schirmfläche eine äquidistante Abbildung von zusammenhängende Reflexe erreicht.

5. Es wird durch eine geeignete Wahl zu gleicher Zeit eine minimale Verzerrung der Abbildung und zwar in jede Richtung um den Primärstrahl herum erreicht.

Die unter Punkt 4 und 5 genannten Vorteile sind dabei nur möglich mit einer Kugelschale.

In der Kristallographie wird alles darauf ausgerichtet, so viel wie möglich an Meßdaten in so kurz wie möglicher Zeit aufzunehmen.

Das hat mit der Länge der Aufnahme insgesamt zu tun und mit der endlichen Lebensdauer des Kristalles zu tun. Eine Detektoranordnung bzw. ein Verfahren, die bzw. das sowohl den Raumwinkel, wie auch die Trennung der Reflexe vergrößert, ist von sehr großem Wert.

Weitere vorteilhafte Ausgestaltungen sind in den abhängigen Ansprüchen gekennzeichnet.

Kurze Beschreibung der Zeichnungen

Nachstehend wird die Erfindung anhand von Zeichnungen näher erläutert. Es zeigen,

Fig. 1            eine Schnittansicht einer bevorzugten Ausführungsform einer erfindungsgemäßen Detektoranordnung,

Fig. 2A bis 2D    verschiedene geometrische Anordnungen einer erfindungsgemäßen Detektoranordnung für die Aufnahme von Röntgenbeugungsbildern.

Fig. 3            eine Schnittansicht einer weiteren bevorzugten Ausführungsform einer erfindungsgemäßen Detektoranordnung.

Fig. 4            in einer schematischen Ansicht die Wirkungsweise der erfindungsgemäßen Detektoranordnung.

Bester Weg zur Ausführung der Erfindung

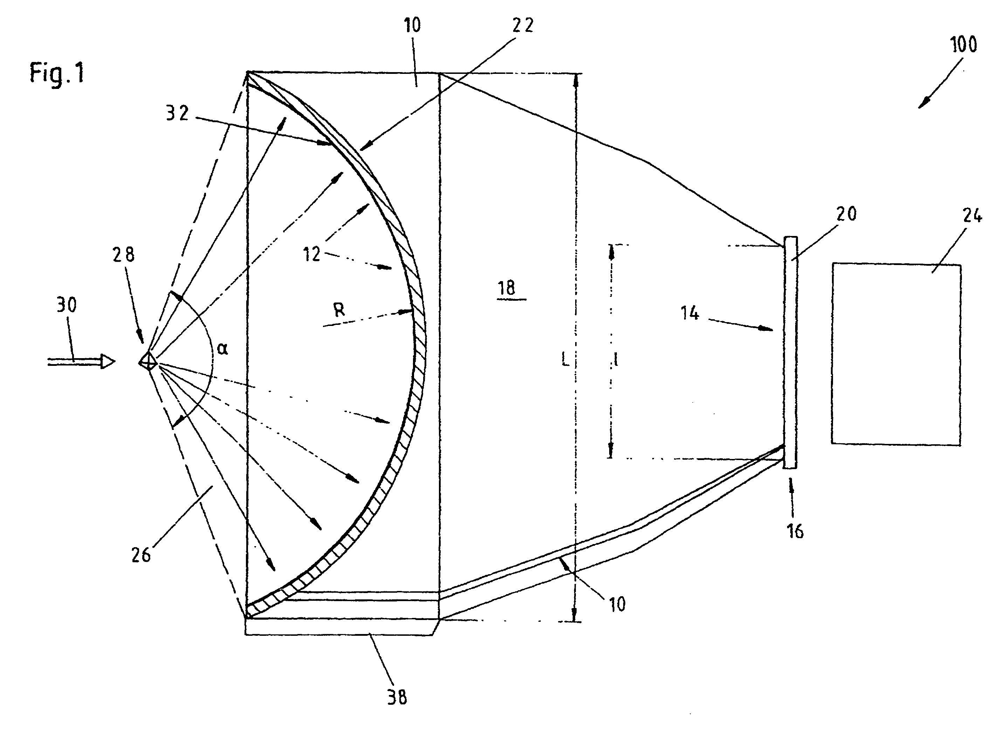

Fig. 1 zeigt eine Schnittansicht einer bevorzugten Ausführungsform einer erfindungsgemäßen Detektoranordnung 100. Mit dieser Anordnung 100 wird ein Objekt 28, beispielsweise ein Einkristall dadurch analysiert, daß ein Primärstrahl 30, beispielsweise ein Röntgenstrahl, auf das Objekt 28 fällt, vom Objekt 28 gestreut wird und als Streustrahlung 26 auf die Eingangs- oder Schirmfläche 12 fällt.

Die Schirmfläche 12 ist eine gekrümmte Fläche und hat in der dargestellten beispielhaften Ausführungsform 100 die Form einer Kugelschale, wobei davon in der Schnittansicht in Fig. 1 ein Halbkreis zu sehen ist. Die Kugelschale hat den Radius R. Ferner weist die Schirmfläche 12 eine Phosphorschicht 22 auf. Diese Schicht 22 setzt die Röntgenstreustrahlung 26 in eine Wellenlänge bzw. Energie der Photonen um, die von einem später beschriebenen Detektor 16 detektiert werden kann.

Vor der Phosphorschicht befindet sich noch eine lichtundurchlässige und röntgenstrahlendurchlässige Schicht oder Fenster 32.

An die Phosphorschicht 22 grenzt ein Glasfaserkörper 10 an. Dieser weist zunächst einen geraden Abschnitt bzw. Lichtleiterteil 38 auf, an den sich ein enger werdender Abschnitt oder Lichtleiterteil 18 anschließt. Dieser Abschnitt 18 setzt das Bild von der Schirmfläche 12 auf die Größe der Detektorfläche 14 um. Es erfolgt sozusagen eine Verkleinerung. An der Detektorfläche 14 ist ein Photonen-Detektor 16, beispielsweise ein CCD-Detektor 20 angeordnet, der von einer Ausleseelektronik 24 ausgelesen wird. Dieses so ausgelesene Beugungsbild kann dann in bekannter Weise zur Analyse des Objekts 28 verwendet werden.

Der Winkel Alpha veranschaulicht in Fig. 1 den maximalen Winkelbereich der Streustrahlung, der von der Schirmfläche 12 erfaßt wird. Dieser Winkel wird als Raumwinkel bezeichnet.

Die das Abbildungsverhalten des Glasfaserkörpers 10 bestimmenden Parameter sind der Radius R der Kugelfläche der Schirmfläche 12, die Länge L der Schirmfläche 12 und die Länge 1 der Detektorfläche 14.

Herkömmliche Glasfaserkörper haben als Schirmfläche eine plane Scheibe mit dem Radius R. Dessen Fläche beträgt somit $\pi R^2$. Gegenüber diesen hat die erfindungsgemäße Ausgestaltung eine Fläche des Schirmes 12 von 2 $\pi R^2$, also eine doppelt so große Fläche.

Der Verkleinerungsmaßstab ist

$$m = L / l \qquad (1).$$

Die Länge L für den Halbkreis ist die Bogenlänge, nämlich

$$L = 2\pi R / 2 = \pi R \qquad (2).$$

Die Länge L für eine flache Schirmfläche ist

$$L = 2 R \qquad (3).$$

Mit (1) ergibt sich somit für m bei identischem 1 und R für eine flache Schirmfläche 12

$$m = 2 R/l \qquad (4)$$

und für die halbkugelförmige Schirmfläche 12 hätte eine äquivalente flache Schirmfläche den Wert

$$m = \pi R/l \qquad (5).$$

Mit anderen Worten: Durch die Geometrie der Kugelfläche hat die Schirmfläche 12 eine doppelt so große Fläche wie eine flache Schirmfläche, jedoch eine gleichbleibende Verkleinerung m = 2.

Dies wird dann interessant, wenn man den Signalverlust SV betrachtet, der mit m quadratisch steigt:

$$SV = m^2 \qquad (6).$$

Für die halbkugelförmige Schirmfläche 12 ergibt sich somit im Vergleich mit einer entsprechenden flachen Schirmfläche ein Signalgewinn von

$$\Delta SV = (3,14 / 2)^2 \approx 2,5 \qquad (7).$$

D. h., die halbkugelförmige Schirmfläche 12 hat gegenüber einer flachen Schirmfläche mit entsprechender Länge L einen Signalgewinn um den Faktor 2,5. Dies verdeutlicht den großen Vorteil der erfindungsgemäßen Anordnung gegenüber herkömmlichen Anordnungen.

Praxisnahe Werte wären beispielsweise für eine flache Schirmfläche:

R = 65 mm
L = 2*65 mm = 130 mm
1 = 49,15 mm
m = L / 1 = 2,64,

was mit (1), (2) und (6) eine Signalabschwächung von 7 ergibt.

Für eine halbkugelförmige Schirmfläche 12 mit R = 65 mm, also entsprechend Außenmaßen des Glasfaserkörpers wie oben, ergibt sich für eine äquivalente flache Schirmfläche:

Bogen:

$\pi$ R = 204 mm
l = 49,15 mm
m = L / l = 4,155,

was mit (1), (2), und (6) eine Signalabschwächung von 17 ergibt. Die erfindungsgemäße Ausführungsform hat somit gegenüber einer bekannten Anordnung mit äquivalenten Maßen einen Signalgewinn von 17/7 = 2,4.

Dieser Signalgewinn wird erzielt durch die Projektion der kugelschalig gekrümmten Schirmfläche auf die flache Ebene des Detektors. Dadurch ergibt sich eine Verengung der Abbildung zum Bildrand hin.

Es ist mathematisch nachweisbar, daß diese scheinbare, nachteilige Abbildung zum Vorteil genutzt werden kann: Im Falle der Aufnahme von Röntgenbeugungsbildern in der Einkristallstrukturbestimmung weiten sich die zu messenden Reflexe umgehend proportional mit dem Cosinus des Streuwinkels auf. Es ist nachweisbar, daß durch die geeignete Wahl des Abstandes, Kristall zur Schirmfläche eines kugelschalenförmigen Detektors die zu messenden Reflexe equidistant abgebildet werden. Diese Tatsache ist von großem Vorteil, bei der Trennung von Reflexen und ist nur mit einer Kugelschalenform zu erreichen.

Fig. 2A bis 2D zeigen verschiedene geometrische Anordnungen zwischen zu analysierendem Objekt 28 und Schirmfläche 12. In Fig. 2A befindet sich das Objekt 28 im Zentrum C der Halbkugelgeometrie der Schirmfläche 12. Der Primärstrahl 30 fällt radial ein. Die detektierte Streustrahlung 26 ist Vorwärtsstreuung. Wie durch Pfeile 34 angedeutet, ist die Detektoranordnung schwenkbar um das Zentrum C angeordnet.

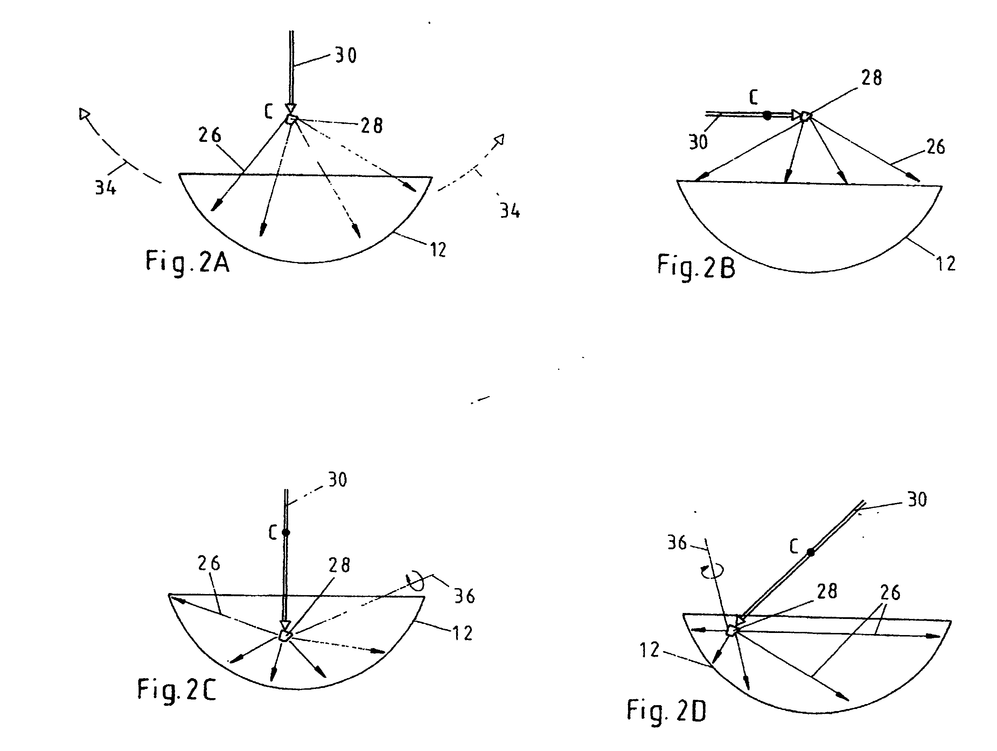

Beim Schwenken um das Zentrum C ist die Geometrie nach Fig. 2B möglich. Das Objekt 28 befindet sich nach wie vor im Zentrum C der Halbkugelgeometrie der Schirmfläche 12, jedoch fällt der Primärstrahl 30 nunmehr tangential ein. Die detektierte Streustrahlung 26 ist Rückwärtsstreuung.

In Fig. 2C ist das Objekt 28 zwischen dem Zentrum C der Halbkugelgeometrie und der Schirmfläche 12 angeordnet. Der Primärstrahl 30 fällt radial ein und es wird Vorwärtsstreuung gemessen. In dieser Anordnung ist der Raumwinkel der erfaßten Streustrahlung 26 größer als 180 Grad.

Eine Drehung der Detektoranordnung um das Zentrum C führt zur Geometrie der Figur 2D. Der Primärstrahl fällt annähernd tangential ein, so daß Rückwärtsstreuung gemessen wird. Der Raumwinkel der erfaßten Streustrahlung 26 beträgt etwa 180 Grad.

In den Fig. 2C und 2D ist mit einer Achse 36 angedeutet, daß das zu analysierende Objekt zusätzlich um die eigene Achse drehbar ist.

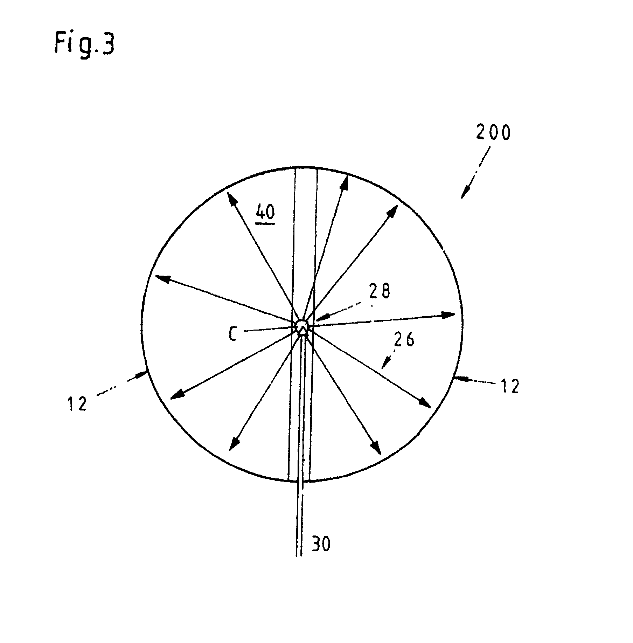

Fig. 3 zeigt eine weitere bevorzugte Ausführungsform 200 einer erfindungsgemäßen Detektoranordnung. Hierbei sind zwei gekrümmte Schirmflächen 12 vorgesehen und einander zugewandt angeordnet. Dabei liegen die beiden Zentren C der Schirmflächen 12 am selben Raumpunkt und genau an diesem Raumpunkt befindet sich ferner der zu untersuchende Einkristall 28. Der Primärstrahl 30 ist zwischen zwei Detektoren mit beispielhaft sphärisch gekrümmter Eingangsfläche derart ausgerichtet, daß er in einen nahezu sphärischen Innenraum 40 der Anordnung 200 eindringt und auf den zu untersuchenden Kristall 28 trifft. Die Streustrahlung 28 wird nunmehr nahezu im gesamten Raumwinkel um den Kristall 28 herum von der Detektoranordnung 200 aufgenommen, so daß mit einer einzigen Messung der gesamte Raumwinkel der gebeugten Röntgenstrahlen 26 erfaßt ist.

Die erfindungsgemäße Detektoranordnung wurde beispielhaft für eine Anordnung zur Aufnahme von Röntgenbeugungsbildern beschrieben, wie dies beispielsweise bei der Kristallstrukturanalyse und der Pulverdiffratometrie der Fall ist. Es ist jedoch klar, daß die Erfindung nicht auf diese Anwendung beschränkt ist. So läßt sich die erfindungsgemäße Detektoranordnung beispielsweise auch zur Detektion von emittierten Photonen, wie beispielsweise Gamma-Strahlung verwenden. Solche Anwendungen gibt es beispielsweise in der Medizin, wo mittels des Isotops $^{133}$Xe re-

gional celebrale Blutflußsysteme (regional cerebral blood flow systems, rCBF) untersucht werden. Auch ergibt sich ein Anwendungsbereich in der Medizin bei CT-Scannern und dentalmedizinischen Anwendungen, wo Röntgenstrahlen zum Durchleuchten angewendet werden.

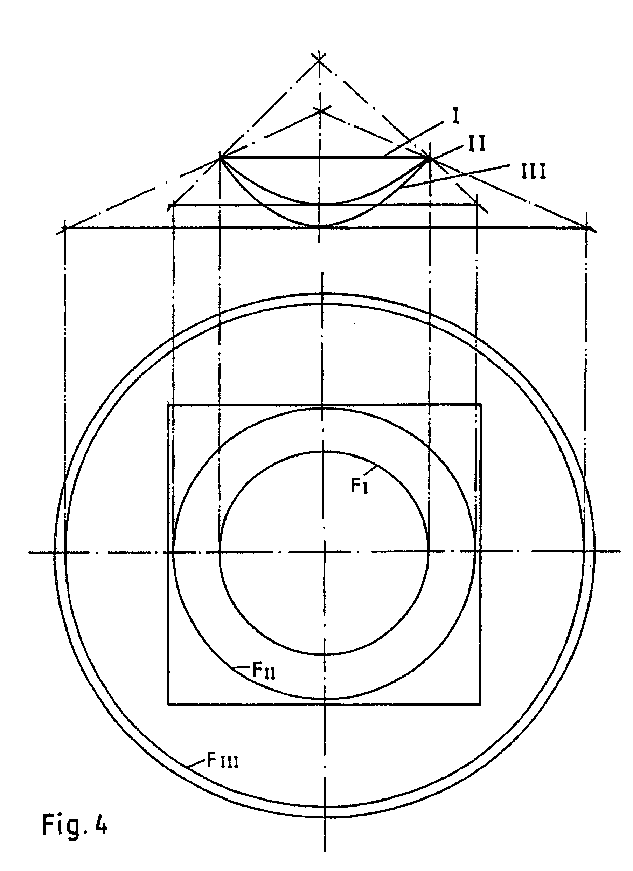

In Fig. 4 ist die erfindungsgemäße Wirkungsweise der Anordnung dargestellt. Durch unterschiedliche Gestaltung der Schirmfläche, nämlich bei I flach, bei II leicht gekrümmt, und bei III stärker gekrümmt, kann man entsprechend große äquivalente Flächendetektoren FI (bei flachen Detektor), FII (bei leicht gekrümmten Detektor) und FIII (bei stärker gekrümmten Detektor) erreichen. Durch die Krümmung kann man daher einen Raumwinkel erreichen, der sonst nur mit einen sehr großen Flächendetektor zu erreichen wäre.

Bezugszeichenliste:

| | |
|---|---|
| Detektoranordnung | 100, 200 |
| Glasfaserkörper | 10 |
| Schirmfläche | 12 |
| Detektorfläche | 14 |
| Photonen-Detektor | 16 |
| Abschnitt zwischen Detektorfläche und Photonen-Detektor | 18 |
| CCD-Detektor | 20 |
| Phosphorschicht | 22 |
| Ausleseelektronik | 24 |
| gebeugte Röntgenstrahlen | 26 |
| Einkristall | 28 |
| Primärstrahl | 30 |
| Fenster | 32 |
| Schwenkbereich | 34 |
| Drehachse des Kristalls | 36 |
| gerader Lichtleiterteil | 38 |
| Innenraum | 40 |
| Raumwinkel | Alpha |
| Schwenkzentrum | C |
| Radius | R |
| Länge der Schirmfläche | L |
| Länge der Detektorfläche | 1 |
| Schirmflächengestaltung | I, II, III |
| äquivalenter Flächendetektor | FI, FII, FIII |

**Patentansprüche**

1. Detektoranordnung (100) für Röntgen-Gamma-Quanten, mit einem Glasfasarkörper (10), der eine Schirmfläche (12) zur Aufnahme von Photonen, eine Detektorfläche (14) mit daran angeordnetem Photonen-Detektor (16) sowie einen dazwischen liegenden Abschnitt (18) aufweist, welcher von der Schirmfläche (12) aufgenommene Photonen zur Detektorfläche (14) leitet, **dadurch gekennzeichnet, dass** die Schirmfläche (12) als eine gekrümmte Fläche ausgebildet ist und dass auf der Schirmfläche (12) eine Schicht (22) zur Umsetzung von Röntgenstrahlen in Photonen an deren Wellenlänge angeordnet ist.

2. Detektoranordnung nach Anspruch 1,
**dadurch gekennzeichnet,**
**dass** die gekrümmte Fläche die Form einer Kugelschale mit Radius R hat.

3. Detektoranordnung nach Anspruch 2,
**dadurch gekennzeichnet,**
**dass** der Radius R einen Wert im Bereich von 50 bis 140 mm, insbesondere 65 mm, hat.

4. Detektoranordnung nach Anspruch 1,
**dadurch gekennzeichnet,**

**dass** die gekrümmte Fläche die Form einer Zylinderschale hat.

5. Detektoranordnung nach Anspruch 1,
**dadurch gekennzeichnet,**
**dass** die gekrümmte Fläche eine parabolische Form hat.

6. Detektoranordnung nach wenigstens einem der vorstehenden Ansprüche,
**dadurch gekennzeichnet,**
**dass** der Detektor (16) ein CCD-Detektor (20) (Charge-Coupled-Device) ist.

7. Detektoranordnung nach wenigstens einem der vorstehenden Ansprüche,
**dadurch gekennzeichnet,**
**dass** sich der Abschnitt (18) zwischen Detektorfläche (14) und Schirmfläche (12) in Richtung Detektorfläche (14) derart verjüngt, dass die Schirmfläche (12) größer als die Detektorfläche (14) ist.

8. Detektoranordnung nach einem der vorstehen den Ansprüche
**dadurch gekennzeichnet,**
**dass** die Schicht (22) eine Phosphorschicht ist.

9. Detektoranordnung nach wenigstens einem der vorstehenden Ansprüche,
**dadurch gekennzeichnet,**
**dass** zwei gekrümmte Flächen derart einander zugewandt angeordnet sind, dass die jeweiligen Zentren der Fläche am selben Raumpunkt liegen.

10. Verfahren zur Kristallstrukturbestimmung, insbesondere Einkristallstrukturbestimmung, mittels einer Detektoranordnung (100) nach einem der Ansprüche 1 bis 9,
**dadurch gekennzeichnet,**
**dass** durch eine geeignete Wahl des Abstandes zwischen dem Kristall, d.h. der Probe und der Schirmfläche die Röntgenreflexe aeqidistant abgebildet werden und/oder minimal verzerrt, d.h. winkeltreu abgebildet werden und zwar in jede Richtung um den Primärstrahl herum, wobei dei gekrümmte Fläche die Form einer Kugelschale unit Radius R hat.

11. Verfahren nach Anspruch 10,
**dadurch gekennzeichnet,**
**dass** durch die Verwendung der gekrümmten, vorzugsweise in Form einer Kugelschale ausgebildeten Schirmfläche die größtmogliche Ausdehnung der Schirmfläche geschaffen wird, die es erlaubt, mehrere Reflexe von einander getrennt abzubilden.

12. Verfahren nach Anspruch 10 oder 11,
**dadurch gekennzeichnet,**
**dass** die Detektion eines größtmöglichen Raumwinkals durchgeführt wird.

13. Verfahren nach einem der Ansprüche 10 bis 12,
**dadurch gekennzeichnet,**
**dass** eine größere Schirmfläche und stärkere Verkleinerung dieser Fläche auf den Detektor erreicht wird ohne Nachtell eines größeren Signalverlustes.

14. Verwendung einer Detektoranordnung (100) nach Auspruch 1 zur Kristallographischen oder tomographischen Structurbestimmung.

**Claims**

1. A detector arrangement (100) for X-ray-gamma quanta with a glas fiber body (10) which has a screen surface (12) for receiving photons, a detector surface (14) with a photon detector (16) placed thereon as well as an intermediate section (18) which transmits the photons received by the screen surface (12) to the detector surface (14), **characterized in that** the screen surface (12) is configured as a curved surface and that a layer (22) is placed on the screen surface (12) for the conversion of X-rays into photons of another wavelength.

2. A detector arrangement according to claim 1, **characterized in that** the curved surface has the shape of a calotte shell with the radius R.

3. A dtector arrangement according to claim 2, **characterized in that** the radius R has a value in the range of 50 to 140 mm, in particular of 65 mm.

4. A detector arrangement according to claim 1, **characterized in that** the curved surface has the form of a cylinder shell.

5. A detector arrangement according to claim 1, **characterized in that** the curved surface has a parabolic shape.

6. A detector arrangement according to at least one of the preceding claims, **characterized in that** the detector (16) is a CCD detector (20) (charge coupled device).

7. A detector arrangement according to at least one of the preceding claims, **characterized in that** the section (18) between the detector surface (14) and the screen surface (12) diminishes in direction of the detector surface (14) in such a way that the screen surface (12) is bigger than the detector surface (14).

8. A detector arrangement according to one of the preceding claims, **characterized in that** the layer (22) is a phosphor layer.

9. A detector arrangement according to at least one of the preceding claims, **characterized in that** two curved surfaces are placed turned to each other in such a way that the respective centers of the surface are situated at the same point in space.

10. A method for the crystal structure analysis, in particular for the monocrystal structure analysis, by means of a detector arrangement (100) according to one of the claims 1 to 9, **characterized in that**, due to an appropriate choice of the distance between the crystal, i.e. the sample and the screen surface, the X-ray reflexes are represented equidistant and/or minimally distorted, i.e. are projected orthomorphically, in any direction around the primary beam, whereby the curved surface has the shape of a calotte shell with the radius R.

11. A method according to claim 10, **characterized in that**, due to the use of the curved screen surface, preferably in form of a calotte shell, the biggest possible extension of the screen surface is created which allows to represent several reflexes separately from each other.

12. A method according to claim 10 or 11, **characterized in that** the detection of a biggest possible solid angle is made.

13. A method according to one of the claims 10 to 12, **characterized in that** a bigger screen surface and a stronger reduction of this surface onto the detector is achieved without the disadvantage of a bigger signal loss.

14. Use of a detector arrangement (100) according to claim 1 for the crystallographic or structure analysis.


**Revendications**

1. Arrangement de détecteur (100) pour des quanta de rayons gamma-rayons X avec un corps en fibres de verre (10) qui présente une surface d'écran (12) pour recevoir des photons, une surface de détecteur (14) avec un détecteur de photons (16) qui y est placé ainsi qu'une section intermédiaire (18) qui conduit les photons reçus par la surface d'écran (12) vers la surface de détecteur (14), **caractérisé en ce que** la surface d'écran (12) est configurée comme une surface courbée et qu'une couche (22) pour la conversion des rayons X en photons d'une autre longueur d'onde est placée sur la surface d'écran (12).

2. Arrangement de détecteur selon la revendication 1, **caractérisé en ce que** la surface courbée a la forme d'une enveloppe de calotte avec un rayon R.

3. Arrangement de détecteur selon la revendication 2, **caractérisé en ce que** le rayon R a une valeur de l'ordre de 50 à 140 mm, en particulier de 65 mm.

**4.** Arrangement de détecteur selon la revendication 1, **caractérisé en ce que** la surface courbée a la forme d'une enveloppe de cylindre.

**5.** Arrangement de détecteur selon la revendication 1, **caractérisé en ce que** la surface courbée a une forme parabolique.

**6.** Arrangement de détecteur selon au moins l'une des revendications précédentes, **caractérisé en ce que** le détecteur (16) est un détecteur CCD (à couplage de charge) (20).

**7.** Arrangement de détecteur selon au moins l'une des revendications précédentes, **caractérisé en ce que** la section (18) entre la surface du détecteur (14) et la surface d'écran (12) s'effile en direction de la surface du détecteur (14) de telle manière que la surface d'écran (12) est plus grande que la surface du détecteur (14).

**8.** Arrangement de détecteur selon l'une des revendications précédentes, **caractérisé en ce que** la couche (22) est une couche de phosphore.

**9.** Arrangement de détecteur selon au moins l'une des revendications précédentes, **caractérisé en ce que** deux surfaces courbées sont placées tournées l'une vers l'autre de telle manière que les centres respectifs de la surface sont situés au même point dans l'espace.

**10.** Procédé pour l'analyse de la structure cristalline, en particulier pour l'analyse de la structure monocristalline, au moyen d'un arrangement de détecteur (100) selon l'une des revendications 1 à 9, **caractérisé en ce que**, grâce à un choix approprié de l'écart entre le cristal, c'est-à-dire l'échantillon, et la surface d'écran, les reflets des rayons X sont représentés équidistants et/ou distordus de manière minimale, c'est-à-dire qu'ils sont représentés conformes, et ce dans chaque direction autour du rayon primaire, la surface courbée ayant la forme d'une calotte avec un rayon R.

**11.** Procédé selon la revendication 10, **caractérisé en ce que**, grâce à l'utilisation de la surface d'écran courbée, configurée de préférence en forme de calotte, la plus grande extension possible de la surface d'écran est créée qui permet de représenter plusieurs reflets séparément l'un de l'autre.

**12.** Procédé selon la revendication 10 ou 11, **caractérisé en ce que** la détection d'un angle solide le plus grand possible est effectuée.

**13.** Procédé selon l'une des revendications 10 à 12, **caractérisé en ce qu'**une plus grande surface d'écran et une réduction plus forte de cette surface sur le détecteur est obtenue sans l'inconvénient d'une plus grande perte de signal.

**14.** Utilisation d'un arrangement de détecteur (100) selon la revendication 1 pour l'analyse structurale cristallographique ou tomographique.

Fig.1

EP 0 916 099 B1

Fig.2B

Fig.2D

Fig.2A

Fig.2C

Fig.3

Fig. 4